# EUROPÄISCHE PATENTSCHRIFT

(11) **EP 1 992 593 B1**
(45) Veröffentlichungstag und Bekanntmachung des Hinweises auf die Patenterteilung: **13.10.2010**
(21) Anmeldenummer: 08155774.6
(22) Anmeldetag: 07.05.2008
(51) Int. Cl.: C01B 33/035, C23C 16/24, C30B 29/06

(54) **Polykristalliner Siliciumstab für das Zonenschmelzverfahren und ein Verfahren zu dessen Herstellung**
Polycrystalline silicon rod for floating zone method and a process for the production thereof
Barreau de silicium polycristallin pour la méthode de fusion en zone flottante et son procédé de fabrication

(30) Priorität: 16.05.2007 DE 102007023041
(43) Veröffentlichungstag der Anmeldung: 19.11.2008
(73) Patentinhaber: Wacker Chemie AG, 81737 München (DE)
(72) Erfinder: Sofin, Mikhail, Dr., 84489 Burghausen (DE); Freiheit, Hans-Christof, Dr., 84489 Burghausen (DE); Kraus, Heinz, 84367 Zeilarn (DE)
(74) Vertreter: Fränkel, Robert

(56) Entgegenhaltungen:
- US-A- 3 540 871
- US-A- 4 255 463
- US-A- 5 310 531
- US-A- 5 976 481
- US-A- 6 060 021
- US-A1- 2003 150 378

## Beschreibung

Die Erfindung betrifft einen Stab aus polykristallinem Silicium zur weiteren Verwendung in der Herstellung eines einkristallinen Stabes mittels eines Schwebezonenverfahrens (FZ-Verfahren) und ein Verfahren zu dessen Herstellung.

Hochreines polykristallines Silicium (Polysilicium) dient als Ausgangsmaterial zur Herstellung von einkristallinem Silicium für Halbleiter nach dem Czochralski-Verfahren (CZ) oder dem Zonenschmelzverfahren (FZ = floating zone) sowie zur Herstellung von Solarzellen für die Photovoltaik.

Polykristalline Siliciumstäbe werden in der Regel nach dem Siemens-Prozess hergestellt. Dabei wird ein siliciumhaltiges Reaktionsgas thermisch zersetzt oder durch Wasserstoff reduziert und als hochreines Silicium an dünnen Filamentstäben aus Silicium, so genannten Dünnstäben oder Seelen, abgeschieden. Als siliciumhaltige Komponente des Reaktionsgases werden überwiegend Halogensilane verwendet, wie beispielsweise Trichlorsilan.

Das Verfahren wird in einem Abscheidereaktor unter Sauerstoffabschluss durchgeführt. In der Regel sind darin zwei benachbarte Dünnstäbe an ihren freien Enden durch eine Brücke zu einem U-förmigen Trägerkörper verbunden. Die U-förmigen Trägerkörper werden durch direkten Stromdurchgang auf die Abscheidetemperatur aufgeheizt und das Reaktionsgas (ein Gemisch aus Wasserstoff und einer siliciumhaltigen Komponente) zugeführt.

Für die Herstellung der polykristallinen Si-Stäbe, die zur Herstellung monokristalliner Si-Stäbe mittels FZ-Verfahren geeignet sind, werden monokristalline (üblicherweise beliebiger Kristallorientierung) Dünnstäbe (Filamentstäbe) eingesetzt. Diese Stäbe werden in einem separaten Schritt einkristallin aus polykristallinen Vorstäben gezogen. Die monokristallinen Dünnstäbe haben meistens einen runden (Durchmesser 5-10 mm) oder quadratischen (Kantenlänge 5-10 mm) Querschnitt. Beim Abscheiden von Silicium zersetzen sich die halogenhaltigen Siliciumverbindungen und setzen sich an der Oberfläche der erhitzten Dünnstäbe als Silicium ab. Dabei wächst der Durchmesser der Stäbe.

Nach dem Erreichen eines gewünschten Durchmessers wird die Abscheidung beendet und die hierbei entstandenen Stabpaare auf Raumtemperatur abgekühlt. Der Formkörper ist üblicherweise U-förmig ausgebildet, mit zwei polykristallinen Stäben als Schenkel und einer die Schenkel verbindenden Brücke aus polykristallinem Si. Die Schenkel sind an ihren Enden mit den Elektroden für die Stromzuführung verwachsen und werden nach Beendigung der Reaktion von diesen getrennt.

Da die Füße und die Brücken der U-förmigen Körper nicht für das FZ-Ziehen verwendet werden können, liegt die Ausbeute an den fertigen polykristallinen Stäben deutlich unter 100 %. Die maximale Länge des abgeschiedenen polykristallinen Si-Stabes ist durch die Länge des eingesetzten Dünnstabes begrenzt. Die Länge des fertigen polykristallinen Si-Stabes bezogen auf die Länge des eingesetzten Dünnstabes wird als Längeausbeute oder einfach Ausbeute bezeichnet. Üblicherweise beträgt die Länge des fertigen polykristallinen Stabes nicht mehr als 85 % der Länge des eingesetzten Dünnstabes.

Bei der Herstellung von polykristallinen Si-Stäben mit dickem Durchmesser wird häufig beobachtet, dass die Stäbe Risse aufweisen oder bei dem Ausbau aus dem Reaktor oder bei der mechanischen Bearbeitung zu fertigen Stäben zerbrechen. Die Risse und Brüche entstehen in Stäben infolge thermischer Spannungen, welche durch die Temperaturunterschiede zwischen dem Stabinneren und der Oberfläche des Stabes verursacht werden. Die Temperaturunterschiede und damit auch die Spannungen sind desto größer, je größer der Durchmesser des Stabes ist. Besonders kritisch werden die thermischen Spannungen, wenn der Stabdurchmesser größer als 120 mm ist.

Die mit Rissen oder hohen thermischen Verspannungen behafteten Stäbe sind für die mechanische Bearbeitung zu den fertigen polykristallinen Stäben sowie für die anschließende Herstellung der einkristallinen Stäbe mittels FZ-Verfahren nicht brauchbar. Meistens brechen die rissigen oder verspannten Stäbe schon bei der mechanischen Bearbeitung. Wenn die Stäbe diese Behandlung überstehen, können sie zu schweren Folgen bei dem Zonenziehen führen. Da bei diesem Verfahren die Stäbe bis zur Schmelztemperatur aufgeheizt werden, können die rissigen oder thermisch verspannten Stäbe infolge zusätzlicher thermischer Spannungen zerspringen. Das führt zu Material- und Zeitverlusten durch Abbruch des Ziehprozesses. Weiterhin kann die Ziehvorrichtung auch durch die abgesprungenen Stabstücke beschädigt werden. Daher müssen rissige und thermisch verspannte polykristalline Siliciumstäbe vor dem Ziehen aussortiert oder bis zur Fehlstelle gekürzt werden. Risse in den polykristallinen Si-Stäben können visuell oder mittels eines bekannten Verfahrens, wie z. B. Klangprüfung oder Ultraschalltechnik detektiert werden. Dieser Materialausschluss reduziert wiederum die Ausbeute. Nach dem Stand der Technik geführte Verfahren ermöglichen eine mittlere Ausbeute an den fertigen rissfreien polykristallinen Si-Stäben für das FZ-Verfahren bezogen auf die Länge der verwendeten Dünnstäbe von nicht mehr als 50 %, wenn der Stabdurchmesser größer als 120 mm ist.

Die defektfreie Ausbeute des gezogenen monokristallinen FZ-Siliciums hängt von der Mikrostruktur des eingesetzten polykristallinen Siliciumstabes ab. Bei der Herstellung der polykristallinen Siliciumstäbe in Siemens-Reaktoren wird Silicium an den einkristallinen Dünnstäben zunächst in einkristalliner Form abgeschieden. Nach einiger Zeit, je nach den Abscheidebedingungen, wechselt das Regime in die polykristalline Form. Dabei wird Silicium sowohl in Form von feinkristalliner Matrix als auch grobkörnigen, meist nadelförmigen, einkristallinen (häufig aber auch als Zwillinge oder Drillinge) Einschlüssen (Nadelkristalle), die in die feinkristalline Matrix eingelagert sind, abgeschieden. Die Nadelkristalle sind überwiegend radial ausgerichtet, wobei ihre Längsachse die <111>-, <100>- oder <110>-Orientierungen zeigen kann. Die inhomogene Mikrostruktur führt dazu, dass die einzelnen Kristallite, entsprechend ihrer Größe beim Durchgang der Schwebeschmelzzone nicht gleichzeitig aufschmelzen. Die wegen ihrer Größe unaufgeschmolzenen Kristallite können als feste Partikel durch die Schmelzzone zu dem einkristallinen Stab durchrutschen und als unaufgeschmolzene Partikel an der Erstarrungsfront des Einkristalls eingebaut werden. An dieser Stelle wird dann eine Defektbildung verursacht.

US-5,976,481 beschreibt ein Verfahren zur Herstellung von Polysiliciumstäben durch Abscheidung von reinem Silicium in der Gasphase aus Trichlorsilan und Wasserstoff an einem erhitzten Siliciumkernmaterial (Filamentstab), der zur Vermeidung der Rissbildung und der Verringerung von Spannungen im Produkt einer thermische Nachbehandlung der polykristallinen Si-Stäbe im Reaktor unter Ausschluss von Luft unterzogen wird. Das Verfahren kann allerdings nur die Bildung solcher Risse vermeiden, die erst nach dem Abscheidungsende bei der Abkühlung der Stäbe entstehen und vermeidet aber nicht die Rissbildung bereits während des Abscheidevorgangs in den Stäben. Weiterhin ist die zusätzliche Wärmebehandlung mit hohne Energiekosten verbunden.

DE-3107260 beschreibt ein Verfahren zur Herstellung von Polysilicium nach dem Siemens-Verfahren an einem Filamentstab, bei dem zur Vermeidung der Rissbildung in den erhaltenen Polysiliciumstäben, nach der Beendigung des Abscheidevorgangs noch nachgeheizt werden. Dabei werden die fertigen Stäbe nicht wie üblich noch weitere 4 bis 5 Stunden an der Heizstromversorgung gelassen und die elektrische Energie dabei langsam abgeregelt, sondern es werden dazu in den Reaktor variable Hitzereflektoren um den heißen Stab positioniert, um dessen Eigenwärme zu nutzen und den Abkühlvorgang ohne zusätzlich Energie zu steuern. Man erhält dabei in Abhängigkeit der der Abkühldauer die gewünschte Kristallqualität.

EP-0445036 beschreibt die Herstellung des mittleren Bereichs des polykristallinen Si-Stabes bei solchen Bedingungen, dass sich dort Silicium nur monokristallin oder grobkristallin abscheidet. Für dieses Verfahren sind allerdings monokristalline Dünnstäbe quadratischen Querschnittes in einer speziellen (Längsachse weist in die <100>-Richtung) Orientierung notwendig, deren Herstellung sehr aufwändig und teuer ist. Außerdem fordert dieses Verfahren hohe Temperatur und niedrige Abscheidegeschwindigkeit. Die geringere Abscheidegeschwindigkeit bedeutet eine niedrigere Wirtschaftlichkeit dieses Abscheidungsprozesses. Die hohe Abscheidetemperatur verursacht hohe thermische Spannungen und führt damit zu rissigen Stäben.

US-3,540,871, US-4,255,463 und DE-2727305 beschreiben Verfahren, wie die monokristalline Abscheidung durch verschiedene Faktoren unterdrückt werden kann, so dass von Anfang an nur polykristallines Silicium aufwächst. Die beschriebenen Methoden können allerdings die Bildung von störenden groben einkristallinen Einschlüssen nicht verhindern. Außerdem führen die vorgeschlagenen Verfahren bei dicken polykristallinen Siliciumstäben mit Durchmesser größer 120 mm zu hohen thermischen Spannungen, so dass die rissfreie Ausbeute an den fertigen Stäben nach der mechanischen Bearbeitung sehr niedrig ist, meistens niedriger als 40 %. In DE2727305 wird vorgeschlagen, wie das Wachstum der grobkristallinen Körner während der Abscheidung unterdrückt werden kann. Dafür wird für ca. 1 Stunde die Temperatur (ausgehend von 1100°C) um 200°C und der Gasdurchfluss um 25 % reduziert und der Molanteil des Halogensilans von 7 - 15 % auf 50 % erhöht. Dieser Schritt wird mehrmals (bis dreimal) wiederholt. Diese Fahrweise beansprucht die Si-Stäbe zusätzlich durch die ständig veränderten thermischen Spannungen und führt zu den sichtbaren Abscheideringen im Gefüge. Diese Ringe in den polykristallinen Si-Stäben stören den FZ-Ziehprozess und verursachen Defekte im einkristallinen FZ-Stab.

Alle bekannten Verfahren aus dem Stand der Technik liefern entweder sehr dünne polykristalline Stäbe oder dickere Stäbe mit Spannungen, die beim Abkühlen oder der Weiterverarbeitung zu Defekten bis hin zur totalen Unbrauchbarkeit des Stabes führen.

Das Ziel der Erfindung ist es, polykristalline Siliciumstäbe mit hoher Ausbeute bei der Herstellung dicker polykristalliner Siliciumstäbe mit Durchmesser größer 120 mm für FZ-Anwendungen bereitzustellen und der häufigen Defektbildung beim Ziehen der polykristallinen Siliciumstäbe zu den FZ-Einkristallen großen Durchmessers entgegenzuwirken. Ein weiteres Ziel der Erfindung ist die Reduzierung der Herstellungskosten der polykristallinen Stäbe durch Einsatz von kostengünstigeren polykristallinen Filamentstäben im Gegensatz zu den im Stand der Technik beschriebenen, aufwändig herstellbaren und damit teureren einkristallinen Filamentstäben.

Gegenstand der Erfindung ist ein Polysiliciumstab erhältlich durch Abscheidung von hochreinem Silicium aus einem siliciumhaltigen Reaktionsgas, das thermisch zersetzt oder durch Wasserstoff reduziert wurde, an einem Filamentstab, **dadurch gekennzeichnet, dass** der Polysiliciumstab im radialen Querschnitt des Stabes mindestens 4 verschiedene Bereiche mit unterschiedlichen Mikrostrukturen besitzt, wobei
a) im innersten Bereich A, der Mitte des polykristallinen Stabes, der polykristalline Dünnstab vorliegt,
b) um diesen Dünnstab ein Bereich B des abgeschiedenen polykristallinen Silicium vorliegt, in dem der Flächenanteil der Nadelkristalle kleiner als 1 % ist, wobei die Nadelkristalle nicht länger als 5 mm und nicht breiter als 1 mm sind,
c) im äußeren Bereich D des polykristallinen Siliciumstabes der Flächenanteil der Nadelkristalle kleiner 7 % ist wobei die Länge der Nadelkristalle kleiner 15 mm und die Breite der Nadelkristalle kleiner 2 mm ist und in diesem äußeren Bereich des polykristallinen Si-Stabes die Länge der Mikrokristalle der Matrix 0,2 mm nicht überschreitet, und
d) zwischen dem Bereich B und D eine Mischzone C vorliegt, bei der das Kristallgefüge fließend von dem Gefüge in Bereich B in das Gefüge in Bereich D übergeht.

Ein weiterer Gegenstand der Erfindung ist die Verwendung eines polykristallinen Dünnstabes als Filamentstab zur Herstellung von polykristallinen Dickstäben für FZ-Anwendungen.

Die in der Erfindung zum Einsatz kommenden polykristallinen Dünnstäbe werden kostengünstig aus dem polykristallinen Dickstab herausgesägt. Sie können eine beliebige Querschnittsform haben, bevorzugt sind die Stäbe mit einem quadratischen Querschnitt, da solche Dünnstäbe am einfachsten hergestellt werden können.

Für die vorliegende Erfindung ist die Form des Dünnstabes nicht von Bedeutung. Bevorzugt werden die Dünnstäbe mit einem quadratischen Querschnitt mit der Kantenlänge von 5 bis 10 mm eingesetzt. Da der Dünnstab nur einen kleinen Volumenanteil des polykristallinen Si-Stabes besitzt, ist seine Mikrostruktur nicht von großer Bedeutung. Bevorzugt erfüllt die Mikrostruktur des Dünnstabes die Anforderungen an die äußere Zone D, besonders bevorzugt an die innere Zone B.

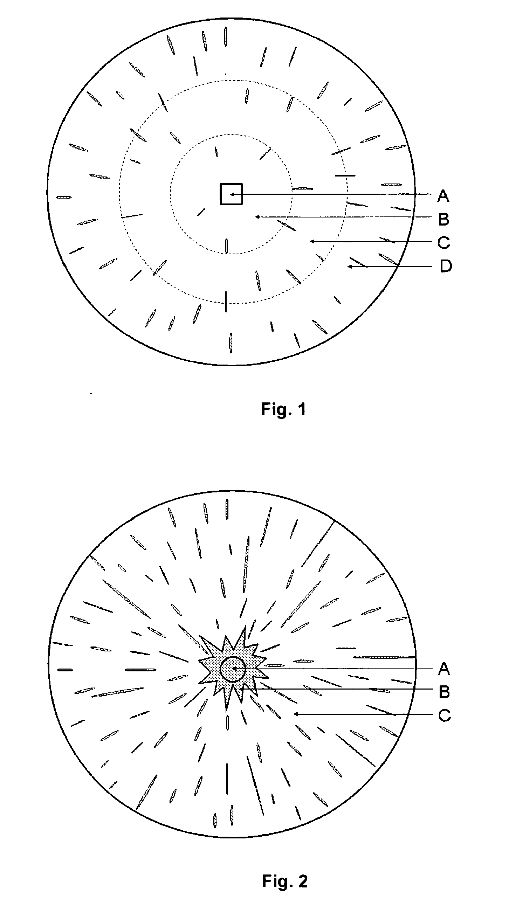

Der Durchmesser des um den Dünnstab liegenden Bereichs B (Fig. 1, B) ist mindestens so groß wie die Schmelzzone beim später verwendeten FZ-Verfahren, vorzugsweise größer 30 mm, besonders bevorzugt größer 80 mm.

Der Flächenanteil der Nadelkristalle im Bereich B ist kleiner als 1 %, wobei die Nadelkristalle nicht länger als 5 mm und nicht breiter als 1 mm sind. Aufgrund der geringen Größe der wenigen Nadelkristalle werden diese beim späteren FZ-Verfahren vollständig aufgeschmolzen und die Möglichkeit, dass die Nadelkristalle oder ihre Reste unaufgeschmolzen die Schmelzzone durchwandern und im späteren einkristallinen Stab einen Defekt verursachen, ist damit ausgeschlossen.

Im äußeren Bereich D des polykristallinen Si-Stabes (Fig. 1, D), ist der Flächenanteil der Nadelkristalle kleiner 7 %, bevorzugt kleiner 5 %, wobei die Länge der Nadelkristalle kleiner 15 mm, bevorzugt kleiner 7 mm und die Breite der Nadelkristalle kleiner 2 mm, bevorzugt kleiner 1,5 mm ist.
Die äußere Zone D beginnt spätestens bei 120 mm des Stabdurchmessers, bevorzugt ab 100 mm. Im diesem äußeren Bereich bilden sich während des Abscheideprozesses die höchsten thermischen Spannungen im polykristallinen Siliciumstab. Durch die feinkristalline Matrix wird die Festigkeit derart erhöht, dass es zu keinen Brüchen und Rissen im Stabbereich außerhalb des Stabfußes an den Elektroden und im Bereich der Brücke kommt.

Die zwischen dem inneren Bereich B (Fig. 1, B) und äußeren Bereich D (Fig. 1, D) entstehende Mischzone C (Fig. 1, C) enthält ein Kristallgefüge, das fließend von dem Gefüge in Bereich B in das Gefüge in Bereich D übergeht. Diese Mischzone liegt im Durchmesserbereich von 30 mm bis 120 mm, bevorzugt im Durchmesserbereich von 50 mm bis 100 mm.

Der erfindungsgemäße Stabquerschnitt enthält keine Abscheideringe. Abscheideringe sind schnelle Gefügeänderungen, die bei schnellen Änderungen der Wachstumsbedingungen, wie zum Beispiel abrupten Änderungen der Abscheidetemperatur oder plötzlichen Änderungen der Feedmengen für die Abscheidung, entstehen. Üblicherweise werden keine Abscheideringe gebildet, wenn Temperatur um weniger als 15°C oder langsamer als 10°C/h oder andere Abscheideparameter (Reaktionsgasdurchsatz, Konzentration der siliciumhaltigen Komponente, Ablagerungsgeschwindigkeit) um weniger als 30 % oder langsamer als 20 %/h geändert werden.

Der Anteil der Nadelkristalle sowie deren Größe der Kristallite können mittels üblicher metallographischer Methoden bestimmt werden. Aus dem Stab wird eine Scheibe senkrecht zur Achsenrichtung des Stabes ausgeschnitten und mindestens einseitig geschliffen und poliert. Für den besseren Kontrast soll die polierte Oberfläche der Si-Scheibe geätzt werden. Die für Si üblichen Ätzmittel sowie Ätzdauer sind z.B. in Metallografie von H. Schumann und H. Oettel (Wiley-VCH, Weinheim, 2005) zu finden. Nach der Einwirkung von Ätzmittel werden die Mikrokristallite des Gefüges unter Lichtmikroskop gut sichtbar und können leicht ausgemessen werden. Dabei erscheinen die Nadelkristalle (grobe einkristalline Einschlüsse) heller als die Matrix. Die Größe der hell erscheinenden Nadelkristalle sowie ihr Flächenanteil kann computergestützt aus elektronischen Aufnahmen ermittelt werden. Als Länge eines Nadelkristalls wird, wie es in der Metallographie üblich ist, sein maximaler Feretdurchmesser und als Breite sein minimaler Feretdurchmesser angenommen.

Figur 1. zeigt eine schematische Ansicht des Querschnittes des polykristallinen Si-Stabes gemäß einer Ausführungsform dieser Erfindung. Im Zentrum des Stabes befindet sich der polykristalline Dünnstab (A) umgeben von der inneren Zone (B).

Daran schließt sich die Mischzone (C) an, die an die äußere Zone (D) grenzt.
Für die bessere Unterscheidung wurden schematisch durch die gestrichelten imaginären Ringe die verschiedenen Bereiche begrenzt. Die Nadelkristalle werden schematisch als graue nadelförmige Bereiche dargestellt.

Figur 2. zeigt als Vergleich eine schematische Ansicht des Querschnittes des polykristallinen Si-Stabes gemäß dem Stand der Technik. Im Zentrum liegt der monokristalline Dünnstab (A) umgeben von einkristallin abgeschiedenem Silicium (B) und polykristallin abgeschiedenem Silicium (C).
Die Nadelkristalle werden schematisch als graue, nadelförmige Bereiche dargestellt.

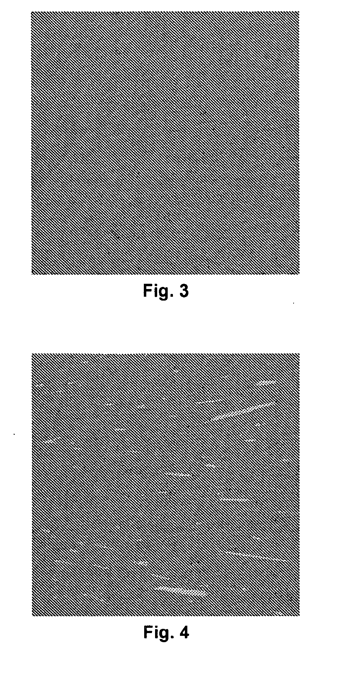

Figur 3. zeigt eine mikrofotografische Aufnahme (Verstärkung von 5) des inneren Bereiches des polykristallinen Si-Stabes gemäß der vorliegenden Erfindung. In der Mitte des linken Bildrandes ist keilförmig ein Teil des polykristallinen Dünnstabes (Zone A) sichtbar. Der Rest des Bildes zeigt die den Dünnstab umgebende innere Zone B, in der keine Nadelkristalle sichtbar sind. Das Gefüge enthält keine Abscheideringe.

Figur 4. zeigt eine mikrofotografische Aufnahme (Verstärkung von 5) des äußeren Bereiches (Zone D) des polykristallinen Si-Stabes gemäß der vorliegenden Erfindung. Nadelkristalle sind hier deutlich als helle Nadeln sichtbar. Das Gefüge enthält keine Abscheideringe.

Beim späteren Zonenziehprozess (FZ-Prozess) fließt das geschmolzene Silicium aus dem äußeren Bereich (Bereich D) in die Schmelzzone. Beim Fließen wird Silicium durchgemischt, so dass die Nadelkristalle vollständig aufschmelzen und den Kristallisationsprozess am einkristallinen Stab nicht negativ beeinflussen. Weiterhin verbleibt den Nadelkristallen genügend Zeit zum Aufschmelzen, da sie vom äußeren Stabbereich des polykristallinen Siliciumstabs bis zum Spulenhals den größten Weg haben. Die erfindungsgemäßen Polysiliciumstäbe können in einem einzigen Durchgang der Schwebeschmelzzone beim FZ-Verfahren einkristallin und defektfrei gezogen werden.

Ein weiterer Gegenstand der Erfindung ist ein Verfahren zur Herstellung eines polykristallinen Siliciumstabes enthaltend die Schritte
a.) Einsatz eines Trägerkörpers in Form eines Filamentstabes aus Silicium,
b.) Einstellung der Stabtemperatur auf 950 bis 1090°C zu Beginn der Abscheidung,
c.) Abscheidung von Silicium aus mit Wasserstoff verdünntem Si-haltigen Gas mit einem molaren Anteil an den Chorsilanverbindungen von höchstens 30 %, wobei der Gasdurchfluss so ausgewählt wird, dass die Si-Ablagerungsgeschwindigkeit 0,2 bis 0,6 mm/h beträgt,
d.) Beibehaltung dieser Bedingungen bis der Stab den Durchmesser von mindestens 30 mm erreicht, so dass der innere Bereich gebildet wird,
e.) spätestens nach Erreichen eines Stabdurchmessers von 120 mm Umstellung der Stabtemperatur auf 930 bis 1030°C und Reduzierung der eingedüsten Wasserstoffmenge, dass der molare Anteil der Chlorsilane im Zugas auf mindestens 35 %, jedoch höchstens 60 % erhöht wird und der Gasdurchfluss dabei so ausgewählt wird, dass die Si-Ablagerungsgeschwindigkeit 0,2 bis 0,6 mm/h beträgt, wobei sich der äußere Bereich bildet,
f.) fließende Umstellung der Prozessbedingungen bei der Herstellung des inneren Bereichs auf die Prozessbedingungen für den äußeren Bereich, wobei der Gasdurchfluss dabei so ausgewählt wird, dass die Si-Ablagerungsgeschwindigkeit 0,2 bis 0,6 mm/h beträgt, und
g.) keine abrupte Änderung der Wachstumsbedingungen während der gesamten Abscheidezeit.

Die erfindungsgemäßen polykristallinen Siliciumstäbe können mit dem Durchmesser ab 120 mm, bevorzugt ab 130, besonders bevorzugt 150 bis 250 mm und mit der mittleren Ausbeute von über 70 % (bezogen auf die Länge der eingesetzten Dünnstäbe) hergestellt werden.

Als Trägerkörper für die Abscheidung des polykristallinen Siliciums werden Dünnstäbe aus polykristallinem Silicium eingesetzt.

Bei dem Beginn der Abscheidung wird die Stabtemperatur auf 950 bis 1090°C, bevorzugt 1000 bis 1075°C, besonders bevorzugt 1010 bis 1050°C eingestellt. Das mit Wasserstoff verdünnte Sihaltige Gas wird in den Reaktor eingedüst. Der molare Anteil an den Chlorsilanverbindungen, bevorzugt Trichlorsilan, beträgt dann höchstens 30 %, bevorzugt 20 bis 25 %. Das Sihaltige Gas zersetzt sich an der heißen Staboberfläche, wobei das Silicium abgelagert wird. Der Gasdurchfluss wird dabei so ausgewählt, dass die Si-Ablagerungsgeschwindigkeit 0,2 bis 0,6 mm/h, bevorzugt 0,25 bis 0,4 mm/h beträgt. Diese Bedingungen werden beibehalten bis der Stab den Durchmesser der Schmelzzone beim FZ-Prozess, üblicherweise mindestens 30 bis 50 mm, bevorzugt mindestens 80 bis 100 mm, erreicht, so dass der innere Bereich gebildet wird. Durch diese Bedingungen wird es gewährleistet, dass in diesem Bereich keine oder nur sehr wenige und kleine Nadelkristalle gebildet werden.

Spätestens wenn der Stab den Durchmesser von 120 mm erreicht, soll die Stabtemperatur auf 930 bis 1030°C, bevorzugt auf 950 bis 1020°C, besonders bevorzugt auf höher als 960°C und niedriger als 990°C, umgestellt und die eingedüste Wasserstoffmenge so reduziert werden, dass der molare Anteil der Chlorsilane im Zugas auf mindestens 35 %, höchstens jedoch 60 % erhöht wird. Der Gasdurchfluss soll so ausgewählt werden, dass die Si-Ablagerungsgeschwindigkeit 0,2 bis 0,6 mm/h, bevorzugt 0,25 bis 0,4 mm/h beträgt. Dabei bildet sich der äußere Bereich mit der feinkristallinen Matrix, wobei der Flächenanteil der Nadelkristalle 7 % nicht überschreitet und sie nicht länger als 15 mm und nicht breiter als 2 mm sind. Diese Bedingungen sollen beibehalten werden, bis der Stab den Zieldurchmesser erreicht. Die durch die Temperaturreduzierung verringerte Ablagerungsgeschwindigkeit wird durch den höheren molaren Anteil an Chlorsilanen kompensiert, so dass keine überproportionale Anhebung des Gasdurchflusses nötig wird. Die Rissfreiheit der Stäbe und damit die Ausbeute von über 70 %, bezogen auf die Länge der Dünnstäbe, wird dadurch erreicht, dass die Stäbe den niedrigeren thermischen Spannungen ausgesetzt sind.

Die niedrigeren Spannungen werden an dieser Stelle durch diese Prozessbedingungen erzeugt, weil die Stäbe eine niedrigere Temperatur haben, das Gasgemisch mit dem niedrigen Wasserstoffanteil eine kleinere Wärmeleitfähigkeit besitzt, so dass die Stäbe thermisch besser isoliert sind, und die Stäbe einem niedrigeren Gasdurchfluss ausgesetzt werden.
Außerdem haben die erfindungsgemäßen Stäbe im äußeren Bereich die feinkristalline Matrix, die thermischen Spannungen besser standhält.

Bevorzugt werden die Prozessbedingungen von denen im inneren Bereich B auf die im äußeren Bereich D fließend umgestellt. Der Gasdurchfluss soll dabei so ausgewählt werden, dass die Si-Ablagerungsgeschwindigkeit 0,2 bis 0,6 mm/h, bevorzugt 0,25 bis 0,4 mm/h beträgt. Wie die Abscheidebedingungen geändert werden sollen, kann aus der Zeit, die für die Abscheidung der Zone C notwendig ist, und dem Unterschied zwischen den Parametern am Ende der Zone B und am Anfang der Zone D berechnet werden. Die Zeit kann aus der Dicke der Zone C und der ausgewählten Abscheidegeschwindigkeit ermittelt werden.

Die Erfindung soll in den folgenden Beispielen näher gezeigt werden.

### Vergleichsbeispiel 1:

Die Abscheidung des in diesem Beispiel beschriebenen polykristallinen Siliciums erfolgte gemäß Stand der Technik. Die runden einkristallinen Filamentstäbe (Durchmesser 8 mm) wurden dem Gemisch aus Trichlorsilan (TCS) und Wasserstoff (molarer Anteil an TCS 20 %) ausgesetzt. Die Stabtemperatur wurde während der gesamten Abscheidezeit auf 1100°C eingestellt. Der Gasdurchfluss wurde so geregelt, dass die Geschwindigkeit der Si-Ablagerung 0,4 mm/h betrug. Nach dem Erreichen des Durchmessers von 150 mm wurde die Abscheidung beendet, Stäbe abgekühlt, aus dem Reaktor entnommen und für das Zonenziehen bearbeitet. Die bearbeiteten Stäbe wurden mittels Ultraschalltechnik, wie in DE102006040486 beschrieben, auf Rissfreiheit kontrolliert. Wenn der Stab mit Rissen behaftet war, wurde der fehlerhafte Bereich abgeschnitten. Wenn das gebliebene Reststück nicht kürzer war als 50 cm, wurde es zum FZ-Ziehen weitergegeben. Die mittlere rissfreie Ausbeute betrug in diesem Fall nur 30 %, bezogen auf die Länge der eingesetzten Dünnstäbe. Dann wurden die Stäbe mittels FZ-Verfahren zu den einkristallinen Stäben gezogen. Aus den bearbeiteten rissfreien polykristallinen Si-Stäben konnten nur 10 % zu den einkristallinen defektfreien Stäben durch einen Schwebezonendurchgang gezogen werden.

### Vergleichsbeispiel 2:

In diesem Beispiel wurde der Herstellungsvorgang der polykristallinen Si-Stäben gleich, wie im Beispiel 1 beschrieben, durchgeführt, mit dem Unterschied, dass der molare Anteil an TCS 50 % betrug, Stabtemperatur auf 1000°C geregelt wurde und der Gasdurchfluss so ausgewählt wurde, dass die Ablagerungsgeschwindigkeit 0,25 mm/h war. Die Rissfreiheit wurde, wie im Beispiel 1 beschrieben ist, kontrolliert. Die mittlere rissfreie Ausbeute betrug in diesem Fall 75 %. 30 % der eingesetzten polykristallinen Stäbe konnten bei einem Durchgang der Schwebezone einkristallin defektfrei gezogen werden.

### Vergleichsbeispiel 3:

In diesem Beispiel wurde der Herstellungsvorgang der polykristallinen Si-Stäben analog zu Beispiel 1, durchgeführt, mit dem Unterschied, dass der molare Anteil an TCS 25 % betrug, die Stabtemperatur auf 1050°C geregelt wurde und der Gasdurchfluss so ausgewählt wurde, dass die Ablagerungsgeschwindigkeit 0,35 mm/h war. Die Rissfreiheit wurde, wie im Beispiel 1 beschrieben ist, kontrolliert. Die mittlere rissfreie Ausbeute betrug in diesem Fall 45 %. Alle polykristallinen Stäbe konnten bei einem Durchgang der Schwebezone einkristallin defektfrei gezogen werden.

### Beispiel 4:

Die Abscheidung der in diesem Beispiel beschriebenen polykristallinen Siliciumstäbe erfolgte gemäß der vorliegenden Erfindung. Als siliciumhaltige Komponente des Reaktionsgases wurde Trichlorsilan verwendet. Als Trägerkörper wurden die polykristallinen Si-Dünnstäbe (quadratischer Querschnitt, Kantenlänge 8 mm) eingesetzt. Zunächst wurde die Abscheidung bei 1050°C mit einem Gasgemisch mit dem TCS-Anteil von 20 % durchgeführt. Die Ablagerungsgeschwindigkeit betrug in diesem Schritt, wie auch in der gesamten Zeit der Abscheidung, 0,35 mm/h. Nachdem die Stäbe den Durchmesser von 60 mm erreicht haben, wurde die Stabtemperatur langsam auf 990°C abgesenkt und gleichzeitig der TCS-Anteil auf 40 % angehoben. Die Änderung erfolgte langsam, so dass sie erst, als der Stab den Durchmesser von 102 mm erreicht hat (nach 60 Stunden), vollzogen war. Dann wurde die Abscheidung bei diesen Bedingungen fortgesetzt, bis die Stäbe den Durchmesser von 150 mm erreicht haben. Nach dem Ausbau aus dem Reaktor konnten die Stäbe mit der mittleren rissfreien Ausbeute von 75 % für das Zonenziehen bearbeitet werden. Die Prüfung auf Risse erfolgte wie im Beispiel 1. Mittels FZ-Verfahren konnten 100 % der eingesetzten polykristallinen Stäbe in einem Schwebezonendurchgang defektfrei einkristallin gezogen werden.

## Patentansprüche

1. Polysiliciumstab erhältlich durch Abscheidung von hochreinem Silicium aus einem siliciumhaltigen Reaktionsgas, das thermisch zersetzt oder durch Wasserstoff reduziert wurde, an einem Filamentstab, **dadurch gekennzeichnet, dass** der Polysiliciumstab im radialen Querschnitt des Stabes mindestens 4 verschiedene Bereiche mit unterschiedlichen Mikrostrukturen besitzt, wobei
a) im innersten Bereich A, der Mitte des polykristallinen Stabes, der polykristalline Dünnstab vorliegt,
b) um diesen Dünnstab ein Bereich B des abgeschiedenen polykristallinen Silicium vorliegt, in dem der Flächenanteil der Nadelkristalle kleiner als 1 % ist, wobei die Nadelkristalle nicht länger als 5 mm und nicht breiter als 1 mm sind,
c) im äußeren Bereich D des polykristallinen Siliciumstabes der Flächenanteil der Nadelkristalle kleiner 7 % ist, wobei die Länge der Nadelkristalle kleiner 15 mm und die Breite der Nadelkristalle kleiner 2 mm ist und in diesem äußeren Bereich des polykristallinen Si-Stabes die Länge der Mikrokristalle der Matrix 0,2 mm nicht überschreitet, und
d) zwischen dem Bereich B und D eine Mischzone C vorliegt, bei der das Kristallgefüge fließend von dem Gefüge in Bereich B in das Gefüge in Bereich D übergeht.

2. Polysiliciumstab für FZ-Anwendungen erhältlich durch Abscheidung von hochreinem Silicium aus einem siliciumhaltigen Reaktionsgas, das thermisch zersetzt oder durch Wasserstoff reduziert wurde, **dadurch gekennzeichnet, dass** der Filamentstab aus polykristallinem Silicium besteht.

3. Polysiliciumstab nach Anspruch 1 bis 2, **dadurch gekennzeichnet, dass** der Durchmesser des erhaltenen Stabes größer 120 mm ist.

4. Polysiliciumstab nach Anspruch 1 bis 3, **dadurch gekennzeichnet, dass** der Filamentstab einen quadratischen Querschnitt mit einer Kantenlänge von 5 bis 10 mm besitzt.

5. Polysiliciumstab nach Anspruch 1 bis 4, **dadurch gekennzeichnet, dass** die Mikrostruktur des Filamentstabes der Mikrostruktur der Zonen B oder D entspricht.

6. Polysiliciumstab nach Anspruch 1 bis 5, **dadurch gekennzeichnet, dass** der Durchmesser des um den Filament liegenden Bereichs B mindestens so groß ist wie die Schmelzzone beim später zu verwendeten FZ-Verfahren.

7. Polysiliciumstab nach Anspruch 6, **dadurch gekennzeichnet, dass** der Durchmesser des um den Filamentstabes liegenden Bereichs B größer 30 mm ist.

8. Polysiliciumstab nach Anspruch 1 bis 7, **dadurch gekennzeichnet, dass** der äußere Bereich D spätestens bei einem Durchmesser von 120 mm des Stabes beginnt.

9. Polysiliciumstab nach Anspruch 1 bis 8, **dadurch gekennzeichnet, dass** die entstehende Mischzone C aus einem Kristallgefüge besteht, das fließend von dem Gefüge im Bereich B in das Gefüge im Bereich D übergeht.

10. Polysiliciumstab nach Anspruch 1 bis 9, **dadurch gekennzeichnet, dass** der Stabquerschnitt keine Abscheideringe enthält.

11. Verfahren zur Herstellung eines polykristallinen Siliciumstabes nach Anspruch 1 bis 10 enthaltend die Schritte
a.) Einsatz eines Trägerkörpers in Form eines Filamentstabes aus Silicium,
b.) Einstellung der Stabtemperatur auf 950 bis 1090°C zu Beginn der Abscheidung,
c.) Abscheidung von Silicium aus mit Wasserstoff verdünnten Si-haltigen Gas mit einem molaren Anteil an den Chorsilanverbindungen von höchstens 30 %, wobei der Gasdurchfluss so ausgewählt wird, dass die Si-Ablagerungsgeschwindigkeit 0,2 bis 0,6 mm/h beträgt,
d.) Beibehaltung dieser Bedingungen bis der Stab den Durchmesser von mindestens 30 mm erreicht, so dass der innere Bereich gebildet wird,
e.) spätestens nach Erreichen eines Stabdurchmessers von 120 mm Umstellung der Stabtemperatur auf 930 bis 1030°C und Reduzierung der eingedüsten Wasserstoffmenge, dass der molare Anteil der Chlorsilane im Zugas auf mindestens 35 %, jedoch höchstens 60 % erhöht wird und der Gasdurchfluss dabei so ausgewählt wird, dass die Si-Ablagerungsgeschwindigkeit 0,2 bis 0,6 mm/h beträgt, wobei sich der äußere Bereich bildet,
f.) fließende Umstellung der Prozessbedingungen bei der Herstellung des inneren Bereichs auf die Prozessbedingungen für den äußeren Bereich, wobei der Gasdurchfluss dabei so ausgewählt wird, dass die Si-Ablagerungsgeschwindigkeit 0,2 bis 0,6 mm/h beträgt, und
g.) keine abrupte Änderung der Wachstumsbedingungen während der gesamten Abscheidezeit.

12. Verfahren nach Anspruch 11, **dadurch gekennzeichnet, dass** der eingesetzte Filamentstab aus polykristallinem Silicium besteht.

13. Verfahren nach Anspruch 11 bis 12, **dadurch gekennzeichnet, dass** die mittlere Ausbeute größer 70 % bezogen auf die Länge der eingesetzten Filamentstabes ist.

## Claims

1. Polysilicon rod obtainable by deposition of high-purity silicon from a silicon-containing reaction gas, which has been thermally decomposed or reduced by hydrogen, on a filament rod, **characterized in that** the polysilicon rod has at least four different regions having different microstructures in the radial cross section of the rod, where
a) the polycrystalline thin rod is present in the innermost region A, the center of the polycrystalline rod,
b) a region B of the deposited polycrystalline silicon, in which region the proportion by area of the needle crystals is less than 1%, where the needle crystals are not longer than 5 mm and not wider than 1 mm, is present around said thin rod,
c) in the outer region D of the polycrystalline silicon rod the proportion by area of the needle crystals is less than 7%, where the length of the needle crystals is less than 15 mm and the width of the needle crystals is less than 2 mm and in this outer region of the polycrystalline Si rod the length of the microcrystals of the matrix does not exceed 0.2 mm, and
d) between the regions B and D a mixed zone C is present, in which the crystal microstructure undergoes transition fluidly from the microstructure in region B to the microstructure in region D.

2. Polysilicon rod for FZ applications obtainable by deposition of high-purity silicon from a silicon-containing reaction gas, which has been thermally decomposed or reduced by hydrogen, **characterized in that** the filament rod is composed of polycrystalline silicon.

3. Polysilicon rod according to Claims 1 to 2, **characterized in that** the diameter of the rod obtained is greater than 120 mm.

4. Polysilicon rod according to Claims 1 to 3, **characterized in that** the filament rod has a square cross section having an edge length of 5 to 10 mm.

5. Polysilicon rod according to Claims 1 to 4, **characterized in that** the microstructure of the filament rod corresponds to the microstructure of the zones B or D.

6. Polysilicon rod according to Claims 1 to 5, **characterized in that** the diameter of the region B lying around the filament is at least as large as the melting zone during the FZ method that is later to be used.

7. Polysilicon rod according to Claim 6, **characterized in that** the diameter of the region B lying around the filament rod is greater than 30 mm.

8. Polysilicon rod as according to Claims 1 to 7, **characterized in that** the outer region D begins at the latest at a diameter of 120 mm of the rod.

9. Polysilicon rod according to Claims 1 to 8, **characterized in that** the resulting mixed zone C comprises a crystal microstructure that undergoes transition fluidly from the microstructure in the region B to the microstructure in the region D.

10. Polysilicon rod according to Claims 1 to 9, **characterized in that** the rod cross section contains no deposition rings.

11. Process for the production of a polycrystalline silicon rod according to Claims 1 to 10, comprising the following steps:
a.) use of a carrier body in the form of a filament rod composed of silicon,
b.) setting the rod temperature to 950 to 1090°C at the beginning of the deposition,
c.) deposition of silicon from Si-containing gas diluted with hydrogen and having a molar fraction of the chlorosilane compounds of at most 30%, where the gas flow is selected such that the Si depositing rate is 0.2 to 0.6 mm/h,
d.) maintaining these conditions until the rod reaches the diameter of at least 30 mm, such that the inner region is formed,
e.) at the latest after a rod diameter of 120 mm has been reached, changing over the rod temperature to 930 to 1030°C and reducing the amount of hydrogen introduced by nozzles such that the molar fraction of the chlorosilanes in the feed gas is increased to at least 35%, but at most 60%, and the gas flow is selected in this case such that the Si depositing rate is 0.2 to 0.6 mm/h, where the outer region is formed,
f.) fluid changeover of the process conditions during the production of the inner region to the process conditions for the outer region, where the gas flow is in this case selected such that the Si depositing rate is 0.2 to 0.6 mm/h, and
g.) no abrupt change in the growth conditions during the entire deposition time.

12. Process as according to Claim 11, **characterized in that** the filament rod used is composed of polycrystalline silicon.

13. Process according to Claims 11 to 12, **characterized in that** the average yield is greater than 70% relative to the length of the filament rod used.

## Revendications

1. Barreau de polysilicium, pouvant être obtenu par dépôt de silicium très pur à partir d'un gaz de réaction contenant du silicium, qui a été décomposé thermiquement ou réduit par de l'hydrogène, sur un barreau filamentaire, **caractérisé en ce que** le barreau de polysilicium présente en section transversale radiale du barreau au moins 4 zones différentes à microstructures distinctes,
a) le mince barreau polycristallin se trouvant dans la zone la plus interne A, le centre du barreau polycristallin,
b) une zone B du silicium polycristallin déposé étant présente autour de ce mince barreau, dans laquelle la proportion en surface des cristaux aciculaires est inférieure à 1 %, les cristaux aciculaires ayant une longueur inférieure ou égale à 5 mm et une largeur inférieure ou égale à 1 mm,
c) la proportion en surface des cristaux aciculaires dans la zone externe D du barreau de silicium polycristallin étant inférieure à 7 %, la longueur des cristaux aciculaires étant inférieure à 15 mm et la largeur des cristaux aciculaires étant inférieure à 2 mm et dans cette zone externe du barreau de silicium polycristallin la longueur des microcristaux de la matrice n'excédant pas 0,2 mm, et
d) une zone mixte C étant présente entre la zone B et la zone D, dans laquelle zone mixte la structure cristalline se transforme en mode flottant de la structure dans la zone B en la structure dans la zone D.

2. Barreau de polysilicium pour des applications FZ (zone flottante) pouvant être obtenu par dépôt de silicium très pur à partir d'un gaz de réaction contenant du silicium, qui a été décomposé thermiquement ou réduit par de l'hydrogène, **caractérisé en ce que** le barreau filamentaire est constitué de silicium polycristallin.

3. Barreau de polysilicium selon les revendications 1 et 2, **caractérisé en ce que** le diamètre du barreau obtenu est supérieur à 120 mm.

4. Barreau de polysilicium selon les revendications 1 à 3, **caractérisé en ce que** le barreau filamentaire présente une section transversale carrée ayant une longueur de côté de 5 à 10 mm.

5. Barreau de polysilicium selon les revendications 1 à 4, **caractérisé en ce que** la microstructure du barreau filamentaire correspond à la microstructure de la zone B ou D.

6. Barreau de polysilicium selon les revendications 1 à 5, **caractérisé en ce que** le diamètre de la zone B se trouvant autour du filament est au moins aussi grand que la zone de masse fondue dans le procédé FZ à utiliser ultérieurement.

7. Barreau de polysilicium selon la revendication 6, **caractérisé en ce que** le diamètre de la zone B se trouvant autour du barreau filamentaire est supérieur à 30 mm.

8. Barreau de polysilicium selon les revendications 1 à 7, **caractérisé en ce que** la zone externe D commence au plus tard à un diamètre de 120 mm du barreau.

9. Barreau de polysilicium selon les revendications 1 à 8, **caractérisé en ce que** la zone mixte C résultante est constituée d'une structure cristalline qui se transforme en mode flottant de la structure dans la zone B en la structure dans la zone D.

10. Barreau de polysilicium selon les revendications 1 à 9, **caractérisé en ce que** la section transversale du barreau ne comporte pas d'anneaux de dépôt.

11. Procédé pour la fabrication d'un barreau de silicium polycristallin selon les revendications 1 à 10, comportant les étapes
a.) disposition d'un corps de support sous forme d'un barreau filamentaire en silicium,
b.) ajustement de la température du barreau à 950-1090 °C au début du dépôt,
c.) dépôt de silicium à partir d'un gaz contenant du silicium, dilué avec de l'hydrogène, ayant une teneur molaire en les composés chlorosilane d'au maximum 30 %, le débit du gaz étant choisi de manière à ce que la vitesse de dépôt du silicium soit de 0,2 à 0,6 mm/h,
d.) maintien de ces conditions jusqu'à ce que le barreau atteigne un diamètre d'au moins 30 mm, de sorte que la zone interne soit formée,
e.) au plus tard après avoir atteint un diamètre du barreau de 120 mm, nouveau réglage de la température du barreau à 930-1030 °C et réduction de la quantité d'hydrogène introduite par des buses, de manière à augmenter la teneur molaire en les chlorosilanes dans le gaz entrant à au moins 35 %, mais à 60 % au maximum, et en même temps le débit du gaz est choisi pour que la vitesse de dépôt du silicium soit de 0,2 à 0,6 mm/h, de sorte que la zone externe se forme,
f.) passage flottant des conditions de processus dans la fabrication de la zone interne aux conditions de processus pour la zone externe, le débit du gaz étant choisi dans ce cas de manière à ce que la vitesse de dépôt du silicium soit de 0,2 à 0,6 mm/h, et
g.) aucun changement brusque des conditions de croissance pendant tout le temps du dépôt.

12. Procédé selon la revendication 11, **caractérisé en ce que** le barreau filamentaire utilisé est constitué de silicium polycristallin.

13. Procédé selon les revendications 11 et 12, **caractérisé en ce que** le rendement moyen est supérieur à 70 %, par rapport à la longueur du barreau filamentaire utilisé.
